# DEMANDE DE BREVET EUROPEEN

(11) **EP 1 763 136 A1**
(43) Date de publication de la demande: **14.03.2007**
(21) Numéro de dépôt: 06015800.3
(22) Date de dépôt: 28.07.2006
(51) Int. Cl.: H03K 3/84

(54) **Procédé de génération de nombres variables**

(30) Priorité: 07.09.2005 FR 0509101
(71) Demandeur: STMICROELECTRONICS SA, 92120 Montrouge (FR)
(72) Inventeur: Moreaux, Christophe, 13109 Simiane (FR); Kari, Ahmed, 13100 Aix En Provence (FR); Naura, David, 13100 Aix en Provence (FR); Rizzo, Pierre, 13100 Aix En Provence (FR)
(74) Mandataire: Marchand, André

(57) **Abrégé**

L'invention concerne un procédé de génération d'un nombre variable comprenant des étapes de génération d'un signal d'horloge (SFo), de démodulation d'un signal de transmission de données reçu, fournissant un signal binaire (RS) comportant des impulsions de fréquence variable, et d'échantillonnage du signal d'horloge (SFo) par le signal binaire (RS), fournissant des échantillons constituant les bits d'un nombre variable (PRN). Application aux puces RFID.

## Description

La présente invention concerne la génération de nombres variables dans un circuit intégré.

La présente invention s'applique notamment, mais non exclusivement aux puces sans contact, telles que les puces RFID (Radio-Frequency IDentification tag). De telles puces comprennent généralement des circuits d'émission et de réception de signaux radioélectriques modulés pour échanger des données avec un lecteur, un circuit d'alimentation électrique pour générer à partir du champ électromagnétique généré par le lecteur une tension d'alimentation du circuit intégré, une unité de traitement, et une mémoire non volatile, par exemple de type EEPROM.

Les nombres variables aléatoires ou pseudo aléatoires sont couramment utilisés dans le domaine de la cryptographie. Par ailleurs, certains protocoles de transmission imposent l'utilisation de nombres variables pour déterminer des délais d'attente. Ainsi, dans le domaine des puces sans contact, une puce doit répondre à un lecteur après un certain délai d'attente. La durée de ce délai est déterminée aléatoirement pour limiter les risques de collision avec les réponses émises par d'autres puces pouvant se trouver dans le champ émis par le lecteur.

Il existe de nombreux procédés pour générer un nombre variable. Ainsi, certains procédés utilisent un signal de bruit qui est échantillonné pour générer un aléa. Dans la demande de brevet EP 1 143 616, un signal en dent de scie est échantillonné par un signal d'horloge ayant une fréquence différente de celle du signal en dent de scie. La tension de chaque échantillon est comparée à une tension de seuil, et le résultat de la comparaison fournit la valeur d'un bit du nombre pseudo aléatoire généré.

Ces procédés nécessitent la mise en oeuvre de nombreux composants, notamment deux oscillateurs décorrélés, qui présentent une consommation électrique non négligeable. Or dans une puce RFID alimentée par le champ électromagnétique émis par un lecteur, il est essentiel que la consommation électrique de la puce soit aussi réduite que possible.

La présente invention a pour objet de générer des nombres variables à l'aide d'un nombre limité de composants présentant une consommation électrique aussi réduite que possible.

Cet objectif est atteint par la prévision d'un procédé de génération d'un nombre variable comprenant une étape de génération d'un signal d'horloge. Selon l'invention, le procédé comprend des étapes de :
- démodulation d'un signal de transmission de données reçu, fournissant un signal binaire comportant des impulsions de fréquence variable, et
- échantillonnage du signal d'horloge par le signal binaire, fournissant des échantillons constituant les bits d'un nombre variable.

Selon un mode de réalisation de l'invention, le signal d'horloge présente une fréquence comprise dans une première bande de fréquences, et la fréquence des impulsions du signal binaire est comprise dans une seconde bande de fréquences plus large que la première bande de fréquences.

Selon un mode de réalisation de l'invention, le signal d'horloge présente une fréquence supérieure à la fréquence des impulsions du signal binaire.

Selon un mode de réalisation de l'invention, le signal d'horloge présente une fréquence plus de dix fois supérieure à la fréquence des impulsions du signal binaire.

Selon un mode de réalisation de l'invention, chaque impulsion du signal binaire est soumise à un délai variable.

De préférence, le délai appliqué à chaque impulsion du signal binaire est déterminé en fonction du nombre variable généré.

Selon un mode de réalisation de l'invention, le délai appliqué à chaque impulsion du signal binaire est généré de manière à être sensible au bruit.

L'invention concerne également un dispositif de génération d'un nombre variable comprenant un générateur d'un signal d'horloge. Selon l'invention, le dispositif comprend :
- un circuit de démodulation démodulant un signal de transmission de données reçu et fournissant un signal binaire comportant des impulsions de fréquence variable, et
- un circuit d'échantillonnage échantillonnant le signal d'horloge par le signal binaire, pour fournir des échantillons constituant les bits du nombre variable généré.

Selon un mode de réalisation de l'invention, le signal d'horloge présente une fréquence comprise dans une première bande de fréquences, et la fréquence des impulsions du signal binaire est comprise dans une seconde bande de fréquences plus large que la première bande de fréquences.

Selon un mode de réalisation de l'invention, le signal d'horloge présente une fréquence supérieure à la fréquence des impulsions du signal binaire.

Selon un mode de réalisation de l'invention, le signal d'horloge présente une fréquence plus de dix fois supérieure à la fréquence des impulsions du signal binaire.

Selon un mode de réalisation de l'invention, le circuit d'échantillonnage comprend un registre à décalage comprenant une entrée de signal d'horloge recevant le signal binaire, une entrée de donnée recevant le signal d'horloge, et une sortie parallèle de nombre variable.

Selon un mode de réalisation de l'invention, le dispositif de génération d'un nombre variable comprend un circuit de délai soumettant à un délai variable chaque impulsion du signal binaire en entrée du circuit d'échantillonnage.

De préférence, le délai appliqué à chaque impulsion du signal binaire par le circuit de délai est ajustable en fonction du nombre variable généré.

Avantageusement, le circuit de délai est réalisé de manière à être sensible au bruit.

L'invention concerne également un circuit intégré comprenant un dispositif de génération d'un nombre variable, tel que défini ci-avant pour déterminer un délai de réponse à un message reçu.

Selon un mode de réalisation de l'invention, le circuit intégré comprend des circuits d'émission et de réception de signaux radioélectriques modulés, et une unité de traitement.

Selon un mode de réalisation de l'invention, les circuits d'émission et de réception comprennent un circuit de démodulation fournissant le signal binaire utilisé pour la génération du nombre variable, le nombre variable étant accessible à l'unité de traitement.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :
- la figure 1 représente sous la forme de blocs un premier mode de réalisation d'un dispositif de génération de nombres variables selon l'invention ;
- la figure 2 est un schéma électronique d'un exemple de registre à décalage utilisé dans le dispositif représenté sur la figure 1 ;
- la figure 3 illustre sous la forme de chronogrammes le fonctionnement du dispositif représenté sur la figure 1 ;
- la figure 4 représente sous la forme de blocs un second mode de réalisation d'un dispositif de génération de nombres variables selon l'invention ;
- la figure 5 illustre sous la forme de chronogrammes le fonctionnement du dispositif représenté sur la figure 4 ;
- la figure 6 est un schéma électronique d'un exemple de circuit de retard à délai réglable utilisé dans le dispositif représenté sur la figure 4 ;
- la figure 7 représente sous la forme de blocs l'architecture d'une puce sans contact intégrant un dispositif selon l'invention.

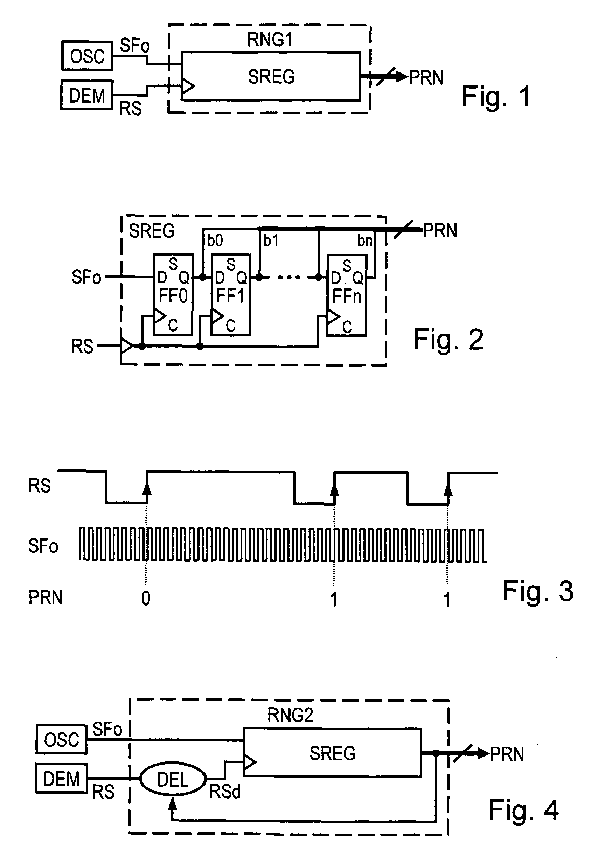

La figure 1 représente un dispositif de génération de nombres variables RNG1 selon l'invention. Sur cette figure, le dispositif RNG1 comprend un registre à décalage SREG comportant une entrée de signal d'horloge et une entrée de signal à échantillonner. L'entrée de signal d'horloge est connectée à la sortie d'un démodulateur DEM fournissant un signal binaire démodulé RS. L'entrée de signal à échantillonner est connectée à la sortie d'un oscillateur OSC fournissant un signal d'horloge SFo.

Le registre à décalage SREG comporte plusieurs cellules, par exemple 16, pour mémoriser autant de bits du mot variable généré. Chaque cellule du registre à décalage est connectée à une sortie parallèle du dispositif RNG1 délivrant en parallèle tous les bits du nombre variable PRN généré.

Le registre à décalage SREG peut être réalisé d'une manière classique illustrée sur la figure 2 à l'aide de bascules D (flip flop) FFO-FFn constituant les cellules du registre. Les bascules sont montées en série (sortie Q connectée à l'entrée D de la bascule suivante). Par ailleurs, l'entrée de signal d'horloge de chaque bascule est connectée à l'entrée de signal d'horloge du registre SREG. La sortie Q de chaque bascule est en outre connectée à la sortie parallèle du registre à décalage. Chaque bascule mémorise donc un bit b0-bn du nombre variable généré qui est accessible sur la sortie parallèle du registre à décalage. Le registre SREG comporte donc un nombre de bascules correspondant à la taille du nombre variable à générer.

La figure 3 représente la forme des signaux d'entrée RS et SFo appliqués en entrée du registre à décalage SREG. Le signal RS est un signal binaire (à deux états) et présente des fronts montants dont la fréquence est variable. Le signal SFo est un signal d'horloge, c'est-à-dire un signal binaire dont la fréquence est sensiblement constante. Comme ce signal est généré localement, sa fréquence peut varier notamment en fonction de la température à laquelle l'oscillateur est soumis, et en fonction de la tension d'alimentation de l'oscillateur. Dans le cas d'une puce sans contact qui est alimentée à partir du champ électromagnétique appliqué à la puce par un lecteur, la tension d'alimentation de la puce dépend de la proximité de la puce avec le lecteur et de l'orientation de celle-ci dans le champ. La tension d'alimentation d'une telle puce est donc très variable.

A chaque front montant du signal RS, un échantillon du signal d'horloge, constituant un aléa égal à 0 ou 1, est prélevé et chargé dans le registre à décalage SREG. La période du signal d'horloge est de l'ordre de 0,5 µs, tandis que le temps séparant deux fronts montants successifs du signal RS varie d'environ 6,25 µs à 50 µs. Par conséquent, la durée séparant deux fronts montants successifs du signal RS, c'est-à-dire la période d'échantillonnage est environ 12,5 à 100 fois plus grande que la période du signal d'horloge. Le nombre variable généré est donc très sensible à une faible variation de la fréquence du signal d'horloge SFo ou de l'écart entre deux fronts montants successifs du signal binaire RS.

Le signal binaire RS provient d'un démodulateur DEM qui démodule un signal transmis sous la forme d'un signal de porteuse modulé. On est ainsi assuré que le signal d'horloge produit par l'oscillateur local OSC de la puce est décorrélé du signal reçu et démodulé RS. Le caractère aléatoire des nombres PRN obtenus en sortie du registre SREG est donc assuré.

Si chaque nombre variable à générer doit comporter un certain nombre de bits, il ne peut être obtenu qu'à la suite de la réception d'autant de fronts montants dans le signal reçu. Le procédé selon l'invention est donc applicable s'il n'est pas nécessaire de disposer d'un nombre variable avant la réception du nombre de fronts montants nécessaire à la génération du nombre variable.

La figure 4 représente un second mode de réalisation du dispositif de génération de nombres variables selon l'invention. Sur cette figure, les éléments identiques à ceux de la figure 1 portent les même références. Le dispositif de génération de nombres aléatoire RNG2 représenté sur cette figure comprend le registre à décalage SREG et un circuit de retard DEL à délai réglable interposé entre la sortie du démodulateur DEM et l'entrée d'horloge du registre à décalage SREG. Le circuit de retard DEL est avantageusement commandé par la sortie du registre SREG pour appliquer à chaque front montant du signal RS un retard variable.

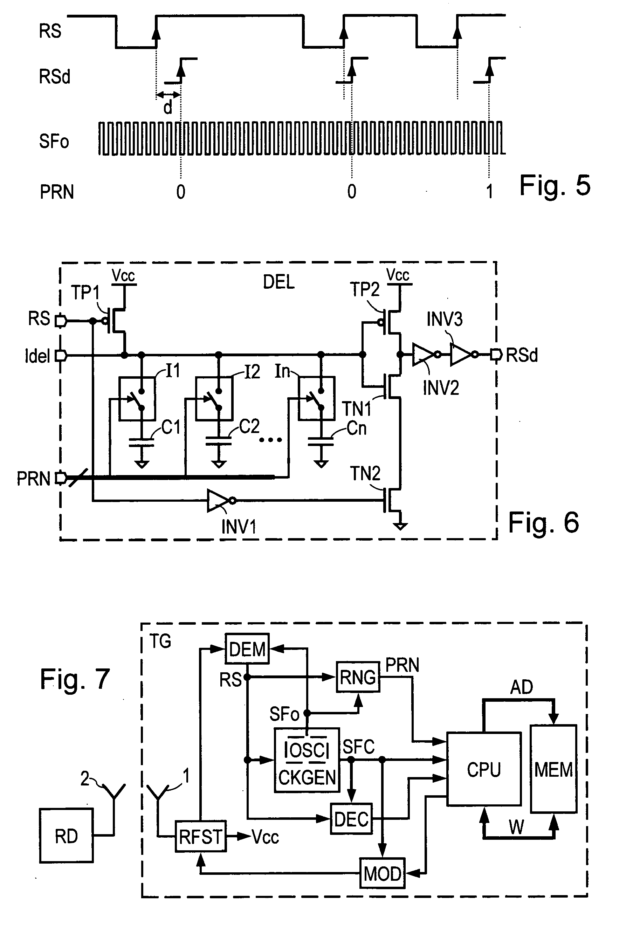

La figure 5 illustre le fonctionnement du dispositif représenté sur la figure 4. La figure 5 représente la forme du signal RS, du signal de sortie RSd du circuit de retard DEL, et du signal d'horloge SFo. Le signal RSd comporte pour chaque front montant du signal RS un front montant retardé d'une durée d variable d'un front à l'autre. Le signal SFo est échantillonné à chaque front montant du signal retardé RSd pour fournir successivement la valeur de chacun des bits du nombre variable PRN, ces bits étant mémorisés dans le registre à décalage SREG.

La figure 6 représente un exemple de circuit de retard à délai variable DEL. Ce circuit comprend un transistor PMOS d'entrée TP1 dont la grille est connectée à une entrée du circuit DEL recevant le signal démodulé RS et dont le drain reçoit la tension d'alimentation Vcc. La source du transistor TP1 est connectée à une entrée connectée à une source de courant constant Idel. Le circuit DEL comprend en outre plusieurs étages capacitifs comprenant chacun un condensateur C1-Cn monté en série avec un interrupteur I1-In dont autre borne est connectée à la source de courant Idel et à la source du transistor TP1. Les interrupteurs I1-In reçoivent sur une entrée de commande la valeur d'un bit du mot variable PRN en sortie du registre à décalage SREG. Le nombre d'étages capacitifs correspond au nombre de bits du mot variable appliqués sur les entrées de commande des interrupteurs. Ainsi, si le nombre de bits des mots variables générés est égal à 16, le nombre d'étages capacitifs est compris entre 1 et 16. Seule une partie des bits du mot variable, par exemple les bits de poids fort ou les bits de poids faible, peut ainsi être utilisée pour commuter les condensateurs C1-Cn.

Le circuit de retard DEL comporte en outre un étage de sortie comprenant trois transistors TP2, TN1 et TN2 montés en série, ainsi que deux inverseurs INV2, INV3 montés en série. La source du transistor TP2 reçoit la tension d'alimentation Vcc et le drain de ce transistor est connecté au drain du transistor TN1, ainsi qu'à l'entrée de l'inverseur INV2. Les grilles des transistors TP2 et TN1 sont connectées au drain du transistor TP1. La source du transistor TN2 est connectée au drain du transistor TN2 dont la source est à la masse et dont la grille est reliée à l'entrée du signal démodulé RS par l'intermédiaire d'un inverseur INV1. Le signal démodulé retardé est obtenu en sortie de l'inverseur INV3.

Lorsque le signal d'entrée RS est à 0, le transistor TP1 est passant. Il en résulte que les condensateurs C1-Cn des étages capacitifs correspondants à un bit à 1 du nombre variable PRN se chargent. Pendant ce temps, la tension de commande appliquée aux grilles des transistors TP2, TN1 et TN2 est à 1. Il en résulte que les transistors TN1 et TN2 sont passants, tandis que le transistor TP2 est non passant. Il en résulte que l'entrée de l'inverseur INV2 est à 0, et donc que le signal de sortie RSd est également à 0.

Lorsque le signal d'entrée RS passe à 1 (arrivée d'un front montant), le transistor d'entrée TP1 et le transistor TN2 se bloquent, ce qui déclenche la décharge à courant constant des condensateurs C1-Cn par la source de courant Idel. La tension appliquée aux grilles des transistors TP2 et TN1 diminue jusqu'à passer en dessous de la tension de seuil des transistors TP2 et TN1. Il en résulte que le transistor TP2 se débloque et le transistor TN1 se bloque. La tension de sortie RSd passe alors à 1.

Un front montant du signal RS appliqué en entrée du circuit de retard DEL est donc retardé d'un délai correspondant au temps de décharge des condensateurs C1-Cn connectés. Le temps de décharge dépend du nombre de condensateurs à décharger, c'est-à-dire connectés et préalablement chargés.

Le circuit à retard DEL est avantageusement réalisé de manière à être sensible au bruit.

L'invention telle que décrite ci-avant s'applique plus particulièrement à un circuit intégré de type puce sans contact tel que représenté sur la figure 7. Sur cette figure, le circuit intégré comprend une unité de traitement CPU couplée à une mémoire MEM. L'unité de traitement communique avec un lecteur externe RD couplé à une antenne 2, à l'aide d'une antenne 1 connectée à un étage radio-fréquence RFST. L'étage RFST est connecté à un démodulateur DEM et à un modulateur MOD. Le démodulateur est connecté à un décodeur DEC qui fournit à l'unité de traitement CPU des données reçues et démodulées. Le modulateur module des données fournies par l'unité de traitement et applique les données modulées à l'étage RFST en vue de leur émission vers le lecteur RD. L'unité de traitement CPU est connectée à la mémoire MEM par des bus d'adresse et de donnée, permettant de transmettre une adresse AD à accéder et un mot W à mémoriser ou lu dans la mémoire à l'adresse AD.

Par ailleurs, l'étage RFST produit à partir d'un champ électrique ou électromagnétique rayonné par le lecteur RD, une tension continue Vcc pour alimenter le circuit intégré TG. Le circuit intégré comprend également un circuit de génération de signal d'horloge CKGEN comprenant un oscillateur local OSC générant un premier signal d'horloge SFo à partir duquel un second signal d'horloge SFC est généré. Le second signal d'horloge SFC est utilisé pour cadencer le modulateur MOD, tandis que le premier signal d'horloge SFo cadence le démodulateur DEM.

La transmission de données entre le circuit intégré TG et le lecteur RD est par exemple effectuée à l'aide d'une modulation ASK (Amplitude Shift Keying) ou PSK (Phase Shift Keying). Le démodulateur DEM fournit au décodeur un signal RS dont la forme correspond à l'enveloppe du signal reçu. Le décodeur échantillonne ce signal à l'aide du signal d'horloge SFo pour obtenir un signal binaire contenant les données reçues.

Le circuit intégré comprend en outre un dispositif de génération de nombres variable RNG selon l'invention, connecté à la sortie de l'oscillateur OSC et à la sortie du démodulateur DEM pour recevoir les signaux SFo et RS. Les nombres variables PRN produits par le dispositif RNG sont accessibles à l'unité de traitement CPU notamment pour déterminer un délai de réponse à un message reçu.

Il apparaîtra clairement à l'homme de l'art que le dispositif selon l'invention est susceptible de diverses variantes. Ainsi, l'invention n'est pas limitée à l'échantillonnage d'un signal d'horloge par un signal ayant une fréquence inférieure à celle du signal d'horloge. En effet, des nombres variables peuvent être obtenus même si cette condition n'est pas satisfaite.

L'échantillonnage du signal d'horloge peut alternativement être effectué sur les fronts descendants du signal démodulé, ou encore sur tous les fronts de ce signal.

Par ailleurs, l'utilisation d'un registre à décalage n'est pas nécessaire, sauf si tous les bits de chaque mot variable généré doivent être fournis en parallèle. En effet, une simple bascule D permet d'échantillonner le signal d'horloge et fournit successivement des aléas pouvant chacun constituer un bit du mot variable.

## Revendications

1. Procédé de génération d'un nombre variable comprenant une étape de génération d'un signal d'horloge (SFo),
**caractérisé en ce qu'**il comprend des étapes de :
- démodulation d'un signal de transmission de données reçu, fournissant un signal binaire (RS) comportant des impulsions de fréquence variable, et
- échantillonnage du signal d'horloge (SFo) par le signal binaire (RS), fournissant des échantillons constituant les bits d'un nombre variable (PRN).

2. Procédé selon la revendication 1, dans lequel le signal d'horloge (SFo) présente une fréquence (Fo) comprise dans une première bande de fréquences, et la fréquence des impulsions du signal binaire est comprise dans une seconde bande de fréquences plus large que la première bande de fréquences.

3. Procédé selon la revendication 1 ou 2, dans lequel le signal d'horloge (SFo) présente une fréquence (Fo) supérieure à la fréquence des impulsions du signal binaire.

4. Procédé selon l'une des revendications 1 à 3, dans lequel le signal d'horloge (SFo) présente une fréquence (Fo) plus de dix fois supérieure à la fréquence des impulsions du signal binaire.

5. Procédé selon l'une des revendications 1 à 4, dans lequel chaque impulsion du signal binaire (RS) est soumise à un délai variable.

6. Procédé selon la revendication 5, dans lequel le délai appliqué à chaque impulsion du signal binaire (RS) est déterminé en fonction du nombre variable généré (PRN).

7. Procédé selon l'une des revendications 1 à 6, dans lequel le délai appliqué à chaque impulsion du signal binaire (RS) est généré de manière à être sensible au bruit.

8. Dispositif de génération d'un nombre variable (PRN) comprenant un générateur (OSC) d'un signal d'horloge (SFo),
**caractérisé en ce qu'**il comprend :
- un circuit de démodulation (DEM) démodulant un signal de transmission de données reçu et fournissant un signal binaire (RS) comportant des impulsions de fréquence variable, et
- un circuit d'échantillonnage (RNG) échantillonnant le signal d'horloge (SFo) par le signal binaire (RS), pour fournir des échantillons constituant les bits du nombre variable généré (PRN).

9. Dispositif selon la revendication 8, dans lequel le signal d'horloge (SFo) présente une fréquence (Fo) comprise dans une première bande de fréquences, et la fréquence des impulsions du signal binaire est comprise dans une seconde bande de fréquences plus large que la première bande de fréquences.

10. Dispositif selon la revendication 8 ou 9, dans lequel le signal d'horloge (SFo) présente une fréquence (Fo) supérieure à la fréquence des impulsions du signal binaire.

11. Dispositif selon l'une des revendications 8 à 10, dans lequel le signal d'horloge (SFo) présente une fréquence (Fo) plus de dix fois supérieure à la fréquence des impulsions du signal binaire.

12. Dispositif selon l'une des revendications 8 à 11, dans lequel le circuit d'échantillonnage (RNG) comprend un registre à décalage (SREG) comprenant une entrée de signal d'horloge recevant le signal binaire (RS), une entrée de donnée recevant le signal d'horloge (SFo), et une sortie parallèle de nombre variable.

13. Dispositif selon l'une des revendications 8 à 12, comprenant un circuit de délai (DEL) soumettant à un délai variable chaque impulsion du signal binaire (RS) en entrée du circuit d'échantillonnage (SREG).

14. Dispositif selon la revendication 13, dans lequel le délai appliqué à chaque impulsion du signal binaire (RS) par le circuit de délai (DEL) est ajustable en fonction du nombre variable généré (PRN).

15. Dispositif selon la revendication 13 ou 14, dans lequel le circuit de délai (DEL) est réalisé de manière à être sensible au bruit.

16. Circuit intégré (TG) **caractérisé en ce qu'**il comprend un dispositif selon l'une des revendications 8 à 15 pour déterminer un délai de réponse à un message reçu.

17. Circuit intégré (TG) selon la revendication 16, comprenant des circuits d'émission et de réception (RFST, MOD, DEM, DEC) de signaux radioélectriques modulés, et une unité de traitement (CPU).

18. Circuit intégré (TG) selon la revendication 17, dans lequel les circuits d'émission et de réception comprennent un circuit de démodulation (DEM) fournissant le signal binaire (RS) utilisé pour la génération du nombre variable (PRN), le nombre variable étant accessible à l'unité de traitement (CPU).
